# EUROPEAN PATENT SPECIFICATION

(11) **EP 1 385 919 B1**
(45) Date of publication and mention of the grant of the patent: **11.08.2004**
(21) Application number: 02722520.0
(22) Date of filing: 10.05.2002
(51) Int. Cl.: C09K 11/06, H01B 1/12, C08G 61/10, H01L 51/20, H01L 51/30, H05B 33/14

(54) **SUBSTITUTED FLUORENE POLYMERS, THEIR PREPARATION AND USES**
SUBSTITUIERTE FLUORENE POLYMERE, IHRE HERSTELLUNG UND VERWENDUNG
POLYMERES DE FLUORENE SUBSTITUTES, LEUR PREPARATION ET LEURS UTILISATIONS

(30) Priority: 11.05.2001 GB 0111549; 29.08.2001 US 315623 P
(43) Date of publication of application: 04.02.2004
(73) Proprietor: Cambridge Display Technology Limited, Cambridge CB3 0TX (GB)
(72) Inventor: TOWNS, Carl R., Cambridge Display Technology Ltd, Cambridge CB3 0TX (GB); O'DELL, Richard, D-84416 Taufkirchen (GB)
(86) International application number: PCT/GB2002/002179
(87) International publication number: WO 2002/092724

(56) References cited:
- EP-A- 0 259 229
- US-A- 5 777 070
- LEE J-I ET AL: "NOVEL POLYMERS BASED ON POLY(FLUORENE)S FOR LED APPLICATIONS" PROCEEDINGS OF THE SPIE, SPIE, BELLINGHAM, VA, US, vol. 3623, January 1999 (1999-01), pages 2-12, XP000951641

## Description

The present invention relates to a polymer and uses thereof such as in an optical device, and to a process for preparing such a polymer.

Organic electroluminescent devices are known which employ an organic material for light emissions. For example, WO 90/13148 describes such a device comprising a semi-conductor layer comprising a polymer film which comprises at least one conjugated polymer situated between electrodes. The polymer film in this case comprises a poly(para-phenylene vinylene) (PPV) which is capable of light emission when electrons and holes are injected therein. Other polymer layers capable of transporting holes or transporting electrons to the emissive layer may be incorporated into such devices.

For organic semiconductors important characteristics are the binding energies, measured with respect to the vacuum level of the electronic energy levels, particularly the "highest occupied molecular orbital" (HOMO) and the "lowest unoccupied molecular orbital" (LUMO) level. These can be estimated from measurements of photoemission and particularly measurements of the electrochemical potentials for oxidation and reduction. It is well understood in this field that such energies are affected by a number of factors, such as the local environment near an interface, and the point on the curve (peak) from which the value is determined. Accordingly, the use of such values is indicative rather than quantitative.

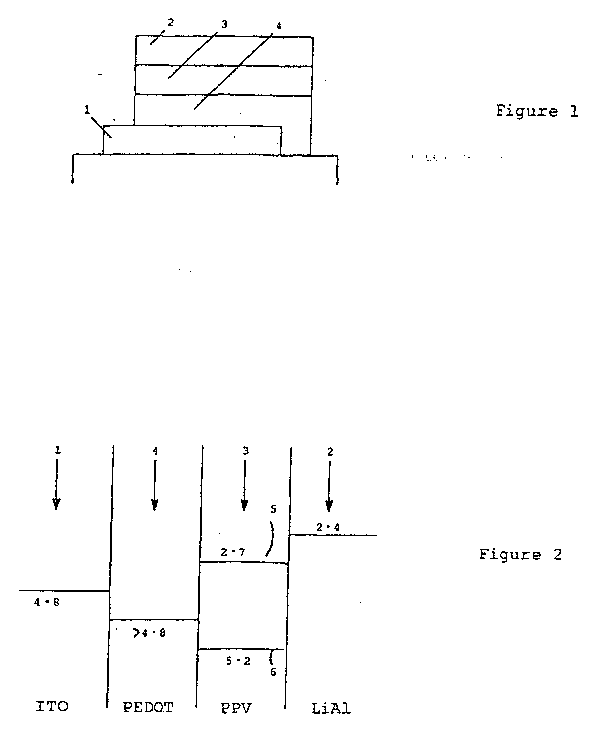

Figure 1 shows a cross section of a typical device for emitting light. Figure 2 shows the energy levels across the device. The anode 1 is a layer of transparent indium-tin oxide (ITO) with a work function of 4.8 electron volts. The cathode 2 is a LiAl layer with a work function of 2.4 electron volts. Between the electrodes is a light-emissive layer 3 of PPV, having a LUMO energy level 5 at around 2.7 electron volts and a HOMO energy level 6 at around 5.2 electron volts. Holes and electrons that are injected into the device recombine radiatively in the PPV layer. An important feature of the device is the hole transport layer 4 of polyethylene dioxythiophene (PEDOT). This polymer is disclosed in EP 0686662. This provides an intermediate energy level at about 4.8 electron volts which helps the holes injected from the ITO to reach the HOMO level in the PPV.

It should be noted here that value stated for energy levels, work functions etc. are generally illustrative rather than absolute. For example, the work function can vary widely. The applicants have carried out Kelvin probe measurements which suggest that 4.8 electron volts is a reasonable value. However, it is well known that the actual value can dependent on ITO deposition process and history.

Known device structures also may have an electron transport layer situated between a cathode 2 and the light emissive layer 3. This provides an intermediate energy level which helps the electrons injected from the cathode to reach the LUMO level of the material constituting the light-emissive layer. Suitably, the electron transporting layer has a LUMO energy level between the LUMO energy levels of the cathode and the light-emissive layer.

In terms of device efficiency, the efficiency of the electron transport material or layer is of great importance. As well as being an efficient electron transporter, an electron transport material also must have suitable device characteristics. That is to say, it must show good processability and lifetime in a device.

JP 07301928 discloses an electrophotographic photoreceptor. JP 7145372 discloses a hole transport material. JP 06107605 discloses a photoconductor for electro photography. All of these materials are small molecules and, thus, have the disadvantages associated with using small molecule layers in a device. None of these documents specifically are concerned with providing an improved electron transport material.

WO 99/54385 is particularly concerned with improving the light output at low drive voltage and efficiency of materials for use in an organic based light-emitting diode (page 1 lines 3 to 7). In this regard, this document discloses a copolymer comprising 10 to 90 %wt of a fluorene group. The fluorene group is substituted in the 9 position by two R¹ groups. Only the embodiment where each R¹ is C₈H₁₇ is exemplified. According to page 2 line 18 to 21 of the description, the copolymers of WO 99/54385 can be used as light-emitting and/or hole transport layer materials in an electroluminescent device. This document is not concerned with providing an improved electron transport material.

Polym. Prepr. (1997) 38(1), 421-422 discloses blue light emitting copolymers of 9,9 di-n-hexylfluorene.

WO 00/22026 discloses blue-blue/green emitting polymers having improved morphological properties. A conjugated polymer containing fluorene structural elements having two different substituents in the C9 position is disclosed.

Whereas US 5777070 is concerned with an improvement to the generally known 'Suzuki reaction' for making conjugated polymers, Example 7 applies this method to the preparation of a copolymer of 9,9-di-n-octylfluorene and 9,9-di-(4-methoxyphenyl)fluorene. WO 99/20675 is the corresponding International patent application to US 5,777,070.

DE 19846767 discloses the preparation of a 9,9-diarylfluorene monomer in section c).

In this regard, one problem with known electron transport materials is their low thermal stability. Physical and conformational changes of materials (polymers) having low thermal stability during device operation leads to a shifting of the emission spectrum of the polymer. In other words, during device operation, the colour of emission from a polymer having low thermal stability is not constant or stable but can change. The glass transition temperature (Tg) value of a material is an indication of its thermal stability in a device. Materials having a high Tg value generally are more thermally stable in a device. Accordingly, for the purposes of improving efficiency, a charge transport material having a higher Tg value would be preferred because of its higher thermal stability.

In this regard, EP 1088875 purports to provide light-emitting polymers with good thermal stability. The good thermal stability is attributed to the incorporation of an adamantane spacer group in the polymers. A copolymer containing adamantane spacer groups is disclosed where the co-repeat unit is diphenylfluorene (polymer 66) or di(4-methoxyphenyl) fluorene (polymer 67). These two polymers are two of a 110 individualised polymers in EP 1088875.

J. Am. Chem. Soc. 2001, 123, 946-953 is concerned with polyfluorenes with dendron side chains. The purpose of the dendrons is to serve as solubilising groups and also to hinder aggregation. The dendron side chains are linked to C9 of the fluorene group by a CH₂ linking group. The protons of the CH₂ linking group are acidic and as such will contribute to instability of the polymer.

In view of the above, there still remains a need to provide an improved electron transport material insofar as it has improved device characteristics that will improve efficiency of the device and device lifetime.

Furthermore, a focus in the field of polymer OLEDs is the development of full colour displays for which red, green and blue emissive materials are required. For commercial applications, it is desirable for the OLED to have a lifetime of several thousand hours. One drawback with existing polymer OLED displays relevant to this development is the relatively short lifetime of blue emissive materials known to date. In view of the above, there still remains a need to provide electroluminescent materials, in particular blue electroluminescent materials, having improved lifetime.

Accordingly, it is an aim of the present invention to provide such a polymer.

It is a further aim of the present invention to provide a method for preparing such a polymer.

Still further, it is an aim of the present invention to provide uses of such a polymer in an optical device, such as, as an electron transport material or as an emissive material.

Accordingly, in a first embodiment of a first aspect of the present invention, there is provided a polymer having a first repeat unit comprising a group having general formula IV which is substituted or unsubstituted: 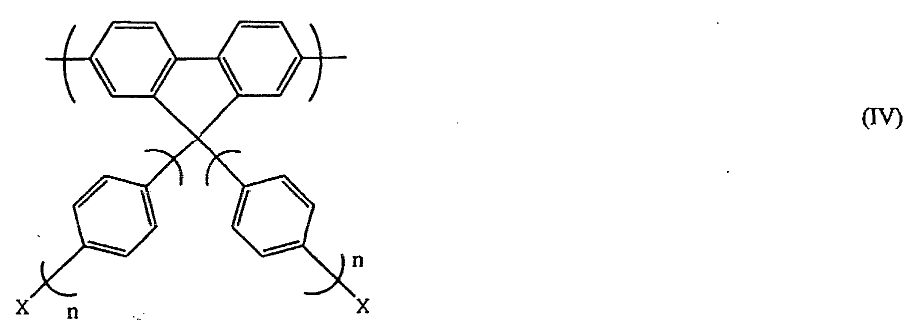 where n is 1, 2 or 3 and X is hydrogen, or an alkyl, aryl, heteroaryl, alkoxy, arylalkyl, alkylaryl, cyano, halide, haloalkyl, haloaryl, haloheteroaryl or haloalkoxy. Preferably X is hydrogen or an alkyl group.

Preferably, in the polymer according to the first aspect, n is 1 and X is hydrogen or an alkyl group.

In one embodiment of the first aspect of the present invention, neither X is substituted or unsubstituted - (-N(aryl)₂, specifically neither X is -(-N(phenyl)₂.

In a second embodiment of the first aspect of the present invention, there is provided a polymer having a first repeat unit comprising a group having general formula I which is substituted or unsubstituted: 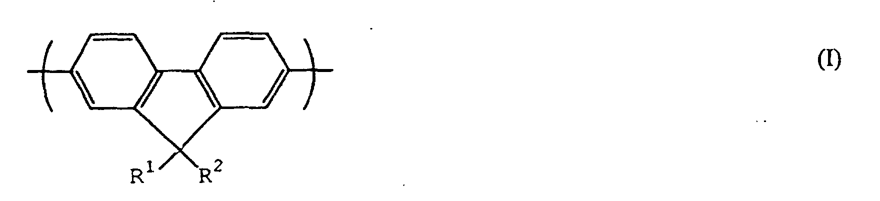 where at least one of R¹ or R² comprises at least two substituted or unsubstituted aryl or heteroaryl groups and excluding the group having general formula I where one or both of R¹ and R² comprises a triarylamine group.

Preferably, for ease of preparation, R¹ and R² are the same. However, R¹ and R² may be different.

In one embodiment, both R¹ and R² do not comprise a substituted or unsubstituted triarylamine.

Polymers according to the first aspect of this invention have superior thermal stability to polymers previously used as electron transport materials. This is evident from their higher Tg values. Tg is measured by Differential Scanning Calorimetry. As a specific example, a polymer comprising 80 mol% dioctylfluorene repeat units was measured to have a Tg of about 80°C. An analogous polymer having 9,9-di(biphenyl)fluorene repeat units in place of 30% of the dioctylfluorene repeat unit was measured to have a Tg of about 175°C. No appreciable shift in the emission spectrum of the polymer was observed by replacing the dioctylfluorene with 9,9-di(biphenyl)fluorene. In addition the thermal stability afforded by materials according to the invention, the present inventors have also shown that incorporation of the Tg enhancing repeat units according to the invention into blue electroluminescent materials can increase the lifetime of an emissive material, in particular a blue electroluminescent material. By "blue electroluminescent material" is meant a material that by electroluminescence emits radiation having a wavelength in the range of 400-500 nm, more preferably 430-500 nm.

Furthermore, it has been established that polymers comprising a repeat unit according to the invention have a higher Tg than a corresponding polymer comprising fluorene repeat units wherein the or each 9 substituent comprises only one aryl substituents. In particular, a polymer comprising 30% 9,9-diphenylfluorene repeat units has a Tg of around 140°C whereas an analogous polymer comprising 30% 9,9-di(biphenyl)fluorene repeat units (described above) has a Tg of around 175°C.

For the reasons discussed above, it is preferred that the Tg value of a polymer according to this invehtion is at least about > 100°C, more preferably 100-230°C.

It is preferred that at least one of R¹ or R² comprises a substituted or unsubstituted phenyl, pyridine or thiophene groups.

Also for reasons of improving electron transport properties, it is preferred that at least one of R¹ and R² comprises a group having general formula II which is substituted or unsubstituted: 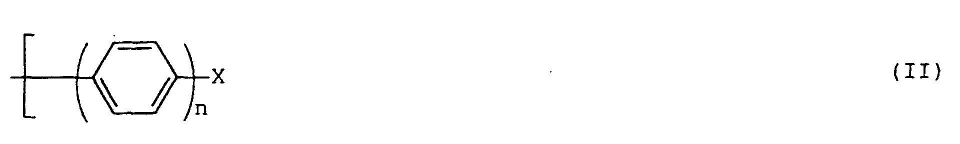 where n is 2 or 3 and X is selected from hydrogen, alkyl, aryl, heteroaryl, alkoxy, arylalkyl, alkylaryl, cyano, halide, haloalkyl, haloaryl, haloheteroaryl or haloalkoxy.

In this regard, it is preferred that the group having general formula I has a formula as shown in general formula III: 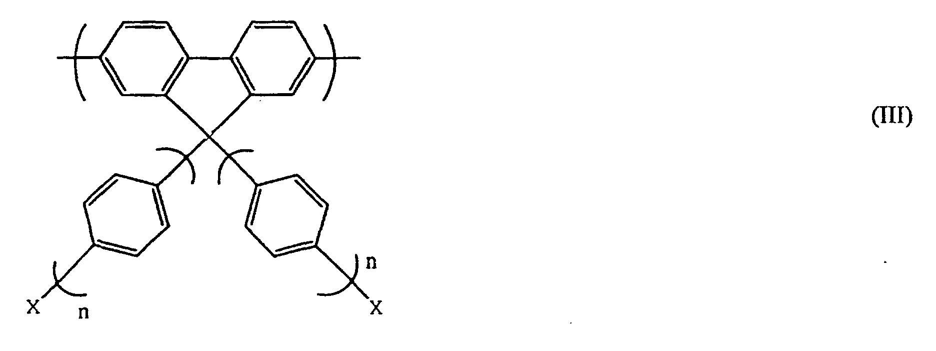 where X and each n independently are as defined above.

Particularly for ease of manufacture, it is preferred that X is selected from hydrogen, alkyl, haloalkyl or alkoxy. For similar reasons, it is further preferred that X is selected from methyl, ethyl, n-butyl, s-butyl or tertiary butyl.

Advantageously, n is 2. In this regard, at least one n may be 2 or both n may be 2. This is because this results in a polymer having a high Tg value and, thus, high thermal stability.

The polymer according to the present invention may comprise further a second repeat unit Ar which comprises a substituted or unsubstituted aryl or heteroaryl group. The ability to select Ar is an important feature, particularly in the design of an electroluminescent device. The structure of Ar may be selected to improve efficiency of a device by modulating the LUMO level of the conjugated backbone to help electron injection from the cathode to the light-emissive material. In this regard, it is preferred that Ar, which is substituted or unsubstituted, comprises a fluorene, phenylene, phenylene vinylene, benzothiadiazole, quinoxaline, thiophene, triarylamine, bis triarylamine or bis(diarylamine)arylene, particularly bis(diphenylamine)benzene groups. Polymers having a repeat unit Ar comprising a group selected from these preferred groups in combination with a first repeat unit as defined above have been found to have desirable properties such as good electron transport and good hole transport properties.

Optionally, the present polymer is soluble. In this regard, solubilising substituent groups can be included in the polymer in order to improve it's solubility. Alkyl and alkoxy groups in particular are preferred to improve solubility.

Broadly speaking, polymers according to the present invention include branched and linear polymers, homopolymers, copolymers and terpolymers. It is envisaged that HOMO polymers and copolymers in accordance with the present invention will be of particular interest with regard to their use in light emitting devices.

The degree of polymerisation of a polymer according to this invention preferably should be at least 4.

Preferred uses of a polymer according to the present invention include use as a component in an optical device, particularly an electroluminescent device. It is envisaged that the polymer will be of most use as an electron transport material

The present invention further provides a monomer comprising a first repeat unit as defined above for transporting negative charge carriers in a polymer according to the present invention. In this regard, a copolymer may be defined to have been made from two or more different monomers. If the copolymer is a regular alternating copolymer, the polymer may be defined to have only one repeat unit. In other words, an AB regular alternating polymer which has been made from monomers A and B may be defined to have an AB repeat unit.

Monomers according to the present invention may be suitable for use in one or more of the polymerisation reactions described in general terms below. In this regard, preferably a monomer comprises one or more reactive groups and a repeat unit as defined in any aspect above. Preferred reactive groups include halide or reactive boron derivatives groups. In particular, bromine, boronic acid, boronic ester and borane groups are preferred.

Generally, several different polymerisation methods are known which may be used to manufacture polymers in accordance with the present invention.

One suitable method is disclosed in WO 00/53656. This describes a process for preparing a conjugated polymer, which comprises polymerising in a reaction mixture (a) an aromatic monomer having at least two boron derivative functional groups selected from a boronic acid group, a boronic ester group and a borane group, and an aromatic monomer having at least two reactive halide functional groups; or (b) an aromatic monomer having one reactive halide functional group and one boron derivative functional group selected from a boronic acid group, a boronic ester group and a borane group, wherein the reaction mixture comprises a catalytic amount of a catalyst suitable for catalysing the polymerisation of the aromatic monomers, and an organic base in an amount sufficient to convert the boron derivative functional groups into -BX₃ anionic groups, wherein X is independently selected from the group consisting of F and OH.

Another polymerisation method is disclosed in US 5,777,070. Commonly, this process is known as "Suzuki Polymerisation". The process involves contacting monomers having two reactive groups selected from boronic acid, C1-C6 boronic acid ester, C1-C6 borane and combinations thereof with aromatic dihalide functional monomers or monomers having one reactive boronic acid, boronic acid, boranic acid ester or boring group and one reactive halide functional group with each other.

A further polymerisation method is known from "Macromolecules", 31, 1099-1103 (1998). The polymerisation reaction involves nickel-mediated coupling of dibromide monomers. This method commonly is known as "Yamamoto Polymerisation".

Accordingly, a second aspect of the present invention provides. a process for preparing a polymer as defined in the first aspect of the present invention which comprises polymerising in a reaction mixture:
(a) a first aromatic monomer comprising either:
   (i) a first repeat unit as defined in relation to the first aspect of the present invention; or
   (ii) a second repeat unit which may be the same or different from the first repeat unit;
   and at least two reactive boron derivative groups selected from a boronic acid group, a boronic ester group and a borane group; and
(b) a second aromatic monomer comprising the other of the first or second repeat units and at least two reactive halide functional groups.

The second aspect of the present invention also provides a process for preparing a polymer as defined in the first aspect of the present invention which comprising polymerising in a reaction mixture:
(a) a first aromatic monomer comprising:
   (i) a first repeat unit as defined in the first aspect of the present invention;
   (ii) a reactive boron derivative group selected from a boronic acid group, a boronic ester group and a borane group; and
   (iii) a reactive halide functional group; and
(b) a second aromatic monomer comprising:
   (i) a second repeat unit that is the same or different from the first repeat unit;
   (ii) a reactive boron derivative group selected from a boronic acid group, a boronic ester group and a borane group; and
   (iii) a reactive halide functional group.

Still further, the second aspect of the present invention provides a process for preparing a polymer comprising a step of reacting a first monomer with a second monomer that may be the same or different from the first monomer under conditions so as to polymerise the monomer, the first monomer being a monomer for use in a polymerisation reaction and comprising one or more reactive groups and a monomeric unit having the structure of a first repeat unit as defined in the first aspect of the present invention.

The present invention further provides an optical device where a component therefore which comprises a substrate and a polymer according to the present invention supported on the substrate. Preferably, the optical device comprises an electroluminescent device. Such an electroluminescent device may comprise a first charge carrier injecting layer for injecting positive charge carriers, a second charge carrier injecting layer for injecting negative charge carriers, a light-emissive layer located between the charge carrier injecting layers for accepting and combining positive and negative charge carriers to generate light and a polymer according to the present invention for transporting negative charger carriers and either located between the second charge carrier injecting layer and the light emissive layer or located in the light-emissive layer. Where it is located in the light-emissive layer, it may be blended with a light-emissive material and optionally a positive charge transport material.

### Examples

### A) Monomer preparation

Monomers according to the invention were prepared in accordance with the general scheme below: 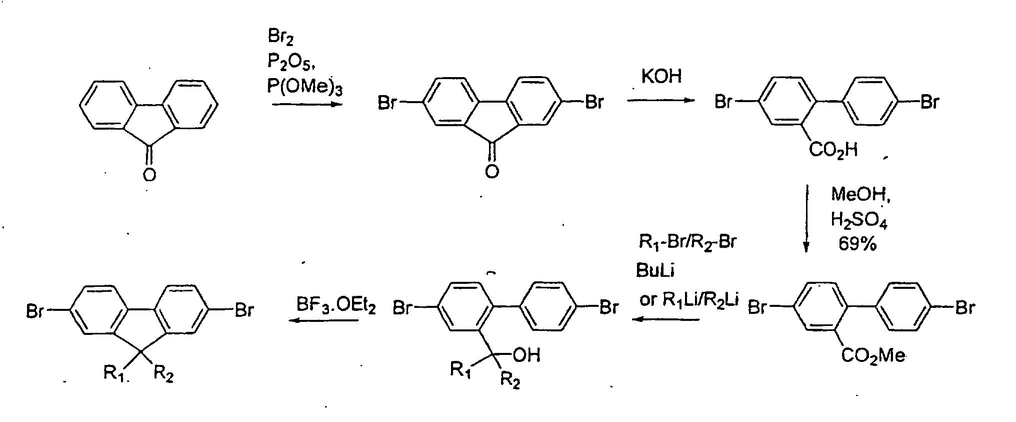 Monomer Example M1: 2,7-Dibromo-9,9-bis(biphenyl)fluorene (R₁=R₂=biphenyl)

### (1) 2,7-Dibromofluorenone

In a 3L flange flask fluorenone (100.006g, 0.555 mol), phosphorus pentoxide (110.148g, 0.776 mol) and trimethylphosphate (1200 mL) were mixed. Under mechanical stirring, a solution of bromine (63 mL, 1.23 mol) in trimethylphosphate (200 mL) was quickly added. This clear solution was then heated for 22 hours at 120 °C. The mixture was allowed to cool to room temperature, then poured into 3L of water. When sodium thiosulfate was added (50.045g) the mixture turned yellow. Stirring was maintained for 1 hour, then the yellow solid was filtered. This solid was heated in methanol to remove the mono-brominated compound and gave 176.183g (98% pure by HPLC, 94% yield).
¹H NMR (CDCl₃) 7.73 (2H, d, *J* 2.0), 7.61 (2H, dd, *J* 7.6, 2.0), 7.36 (2H, d, *J* 8.0) ; ¹³C NMR (CDCl₃) 142.3, 137.5, 135.3, 127.9, 123.3, 121.8, 109.8.

### (2) 4,4'-Dibromo-2-carboxylic aaid-1,1'-biphenyl

In a 2L flange flask 2,7-dibromofluorenone (120.526g, 0.356 mol), potassium hydroxide (finely powdered flakes, 168.327g, 3.000 mol) and toluene (600 mL) were placed. This mixture was heated at 120 °C for four hours then left to cool to room temperature. Water was added to dissolve the solid (∼ 2L) under vigorous stirring. The greenish aqueous layer was removed and the yellow toluene layer was washed twice with water. The combined aqueous layers were acidified with concentrated hydrochloric acid then the precipitated solid was filtered, dried then recrystallised from toluene to give 100.547g of off white crystals (79% yield).
¹H NMR ( (CD₃)₂CO) 8.00 (1H, d, *J* 2.0), 7.77 (1H, dd, *J* 8.0, 2.4), 7.57 (2H, d, *J* 8.0), 7.34 (1H, d, *J* 8.4), 7.29 (2H, d, *J* 8.8) ; ¹³C NMR ((CD₃)₂CO) 167.1, 140.4, 139.8, 134.2, 133.5, 132.8, 132.7, 131.2, 130.6, 121.4, 121.1.

### (3) 4,4'-Dibromo-2-methyl ester-1,1'-biphenyl

4,4-dibromo-2-carboxylic acid biphenyl (171.14g, 0.481 mol) was suspended in methanol (700 mL) and sulfuric acid (15 mL) then heated at 80 °C for 21 hours. The solvent was removed and the oil was dissolved in ethyl acetate. This solution was washed with 2N sodium hydroxide, water, saturated sodium chloride, dried over magnesium sulfate, filtered and evaporated to give an orange oil. This oil was treated with hot methanol, on cooling the ester precipitated out and was filtered. The mother liquor was evaporated and the solid recrystallised giving additional product. The ester was 100% pure by GCMS, a yield of 123.27g (69%) was obtained. ¹H NMR (CDCl₃) 7.99 (1H, d, *J* 2.0) , 7.64 (1H, dd, *J* 8.0, 1. 6), 7.51 (2H, d, *J* 8.4), 7.19 (1H, d, *J* 8.8), 7.13 (2H, d, *J* 8.8), 3.67 (3H, s); ¹³C NMR (CDCl₃) 167.1, 140.3, 139.1, 134.4, 132.9, 132.1, 132.0, 131.3, 129.8, 121.9, 121.5, 52.3.
GCMS: M⁺ = 370
**Literature ref: J.Am.Chem.Soc., 114, 15 (1992)**

### (4) 4,4'-Dibromo-2-bis(biphenyl) methyl alcohol Biphenyl

4-Bromobiphenyl (63.766g, 0.27mol) was dissolved in dry THF (400ml). The solution was then cooled to -65°C, at which point n-BuLi (109ml, 2.5M in hexanes, 0.27mol) was added dropwise with stirring. When the addition was complete the mixture was stirred at -65°C for an hour. A solution of 4,4'-Dibromo-2-methyl ester biphenyl (39.14g, 0.106mol) in dry THF (200ml) was added dropwise, with care being taken to keep the temperature of the mixture below -60°C. When the addition had been completed the mixture was allowed to warm to room temperature. The reaction was quenched with water (10ml) and the solvent evaporated. The residue was then dissolved in toluene and washed with saturated ammonium chloride solution and brine. The solution was dried (MgSO₄) and evaporated; the product was then treated with petroleum ether (100-120°C) and a little ethyl acetate. The resulting crystals were filtered and dried, giving 54.535g (78%).

### (5) 2,7-Dibromo-9,9-bis(biphenyl) fluorene

The alcohol (14.03g, 21.7mmol) was dissolved in dichloromethane (70ml); the resulting solution was cooled with an ice bath. Boron trifluoride diethyletherate (14ml) was added dropwise, giving a deep blue mixture. The mixture was poured into 2 litres of ice-water, potassium carbonate was added until the mixture was basic (pH 8). Dichloromethane was added and separated, the aqueous phase was then extracted with more dichloromethane. The organic phases were combined, filtered through celite and precipitated in methanol. The resulting solid was filtered and recrystallised several times from ethyl acetate / dichloromethane (50/50) to give 3.28g (24% yield, 99.44% by HPLC)

### Monomer Example M2: 2,7-dibromo-9, 9-bis (4-tert-butylbiphenyl)fluorene

The synthesis of monomer example M1 was followed except that 4-bromo-4'-tert-butyl-1,1'-biphenyl was used in place of 4-bromobiphenyl.

### B) Polymer preparation

### Polymer Example P1

A blue emissive polymer according to the invention was prepared in accordance with the process of WO 00/53656 by reaction of 9,9-di-n-octylfluorene-2,7-di (ethylenylboronate) (0.5 equivalents), 2,7-dibromo-9,9-diphenylfluorene (0.3 equivalents), N,N-di(4-bromophenyl)-sec-butylphenylamine (0.1 equivalents) and N,N'-di(4-bromophenyl)-N,N'-di(4-n-butylphenyl)-1,4-diaminobenzene (0.1 equivalents) to give polymer P1:

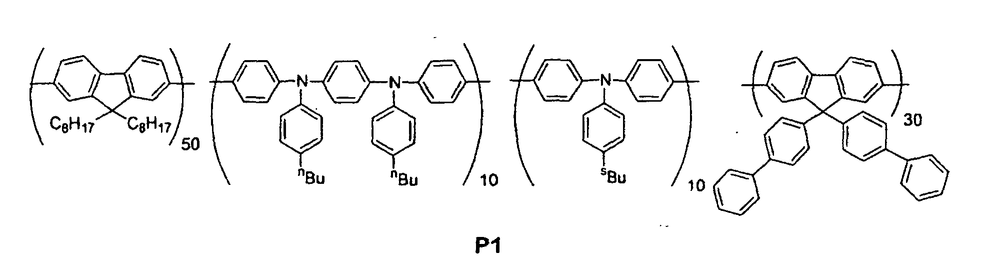

### Polymer P1 has a Tg of 175°C

### Comparative Polymer Example

A blue electroluminescent polymer, as disclosed in WO 00/55927, was prepared in accordance with polymer example 1 wherein all 9,9-diphenylfluorene repeat units were replaced with 9,9-di-n-octylfluorene repeat units. This was done by following the preparation of polymer example 1 except that 0.3 equivalents of 2,7-dibromo-9,9-di-n-octylfluorene was used in place of 2,7-dibromo-9,9-diphenylfluorene.

The polymer according to this comparative example has a Tg of around 80°C.

### C): Optical Device Example

Onto a glass substrate carrying an ITO substrate of thickness 270 microns was deposited by spin coating poly(ethylenedioxythiopene)/polystyrene sulfonate (available from Bayer™ as Baytron P™) to a thickness of 270 microns. Over this was deposited a polymer according to the invention to a thickness of 50 nm by spin coating. A layer of lithium fluoride (thickness 4 nm) was deposited onto the polymer by evaporation followed by a cathode of calcium (thickness 50 nm), again deposited by evaporation. The device was encapsulated using a metal can.

The lifetime of the device is around 3000 hours or more (by "lifetime" is meant the time for the brightness of the device to fall from 100 cd/m² to 50 cd/m² under DC drive at room temperature).

### Comparative Device Example

A device analogous to the above optical device example was prepared except that the comparative polymer described above was used. The lifetime of this device is around 1000 hours.

Polymer P1 and the comparative polymer example are both blue electroluminescent polymers.

## Claims

1. A polymer having a first repeat unit comprising a group having general formula I which is substituted or unsubstituted: 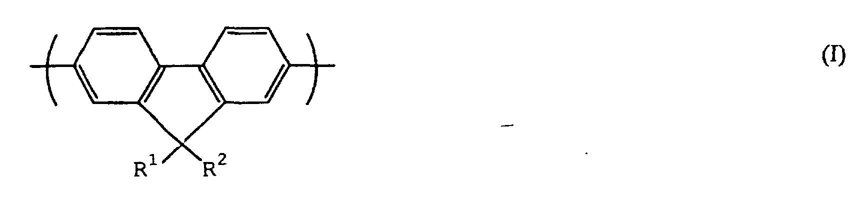 where at least one of R¹ or R² comprises at least two substituted or unsubstituted aryl or heteroaryl groups and excluding the group having general formula I where one or both of R¹ and R² comprises a triarylamine group.

2. A polymer according to claim 1, wherein R¹ and R² are the same.

3. A polymer according to claim 1, wherein R¹ and R² are different.

4. A polymer according to any one of claims 1 to 3, wherein at least one of R¹ or R² comprises a substituted or unsubstituted phenyl, pyridine, or thiophene group.

5. A polymer according to any one of claims 1 to 4, wherein at least one of R¹ or R² comprises a group having general formula II which is substituted or unsubstituted: 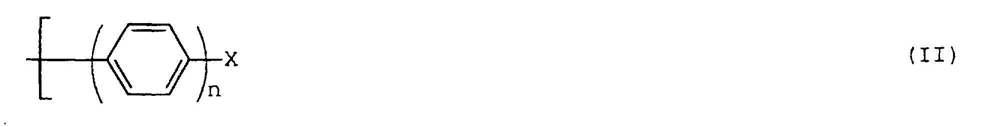 where n is 2 or 3 and X is selected from hydrogen, alkyl, aryl, heteroaryl, alkoxy, arylalkyl, alkylaryl, cyano, halide, haloalkyl, haloaryl, halohetoraryl or haloalkoxy.

6. A polymer according to claim 5, wherein the group having general formula I has a formula as shown in general formula III: 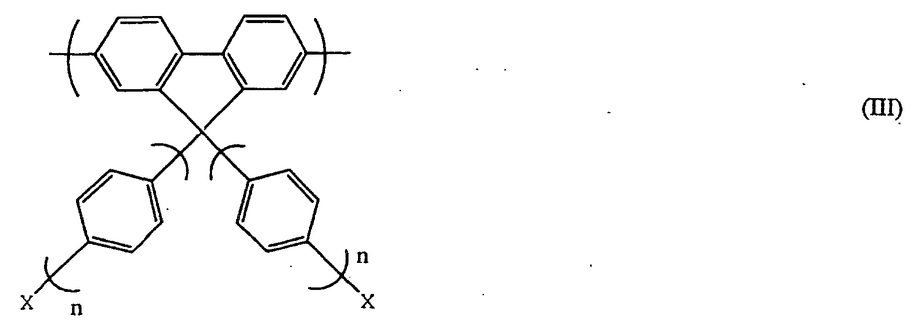 where X and each independently n are as defined in claim 5.

7. A polymer according to claim 5 or claim 6; where X is selected from hydrogen, alkyl, haloalkyl or alkoxy.

8. A polymer according to claim 7, wherein X is selected from methyl, ethyl, n-butyl, s-butyl, tertiary butyl.

9. A polymer according to any one of claims 6 to 8, wherein n is 2.

10. A polymer according to any one of the preceding claims, further having a second repeat unit † Ar † which comprises a substituted or unsubstituted aryl or heteroaryl group.

11. A polymer according to claim 10, wherein Ar is substituted or unsubstituted and comprises a fluorene, phenylene, phenylene vinylene, benzothiadiazole, quinoxaline, thiophene, triarylamine, bis triarylamine or bis (diarylamine) arylene group.

12. A polymer according to any one of the preceding claims, which polymer comprises a homopolymer.

13. A polymer according to any one of claims 1 to 11, which polymer comprises a copolymer.

14. A polymer according to any one of the preceding claims, wherein the degree of polymerisation is at least 4.

15. A polymer according to any one of the preceding claims, wherein the Tg is at least 100°C.

16. Use of a first repeat unit as defined in any one of claims 1 to 9 for transporting negative charge carriers in a polymer according to any one of the preceding claims.

17. Use of a polymer as defined in any one of claims 1 to 15 as a component in an optical device.

18. Use of a polymer according to claim 17, wherein the optical device comprises an electroluminescent device.

19. An optical device or a component therefor, which comprises a substrate and a polymer as defined in any one of claims 1 to 15 supported on the substrate.

20. An optical device or a component therefor according to claim 19, wherein the optical device comprises an electroluminescent device.

21. An optical device according to claim 20, wherein the electroluminescent device comprises:
a first charge carrier injecting layer for injecting positive charge carriers;
a second charge carrier injecting layer for injecting negative charge carriers;
a light-emissive layer located between the charge carrier injecting layers for accepting and combining positive and negative charge carriers to generate light; and
a polymer as defined in any one of claim 1 to, 15 for transporting negative charge carriers and either located between the second charge carrier injecting layer and the light-emissive layer or located in the light-emissive layer.

22. A monomer for use in a polymerisation reaction, comprising one or more reactive groups and a monomeric unit having the structure of a first repeat unit as defined in any one of claims 1 to 9.

23. A process for preparing a polymer comprising a step of reacting a first monomer as defined in claim 22 with a second monomer that may be the same or different from the first monomer under conditions so as to polymerise the monomers.

24. A process according to claim 23 for preparing a polymer as defined in any one of claims 1 to 15 which comprises polymerising in a reaction mixture:
(a) a first aromatic monomer comprising either:
(i) a first repeat unit as defined in any one of claims 1 to 9; or
(ii) a second repeat unit which may be the same or different from the first repeat unit,
and at least two reactive boron derivative groups selected from a boronic acid group, a boronic ester group and a borane group; and
(b) a second aromatic monomer comprising the other of the first or second repeat units and at least two reactive halide functional groups.

25. A process according to claim 23 for preparing a polymer as defined in any one of claims 1 to 15 which comprises polymerising in a reaction mixture:
(a) a first aromatic monomer comprising:
(i) a first repeat unit as defined in any one of claims 1 to 9;
(ii) a reactive boron derivative group selected from a boronic acid group, a boronic ester group and a borane group; and
(iii) a reactive halide functional group; and
(b) a second aromatic monomer comprising
(i) a second repeat unit that is the same or different from the first repeat unit;
(ii) a reactive boron derivative group selected from a boronic acid group, a boronic ester group and a borane group; and
(iii) a reactive halide functional group.

## Patentansprüche

1. Polymer mit einer ersten sich wiederholenden Einheit, die eine substituierte oder unsubstituierte Gruppe der allgemeinen Formel I umfaßt: 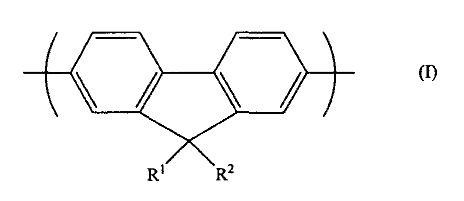 worin R¹ und/oder R² mindestens zwei substituierte oder unsubstituierte Aryloder Heteroarylgruppen umfaßt, mit Ausnahme derjenigen Gruppe der allgemeinen Formel I, worin einer der Reste R¹ und R², oder beide, eine Triarylamingruppe umfaßt bzw. umfassen.

2. Polymer nach Anspruch 1, worin R¹ und R² gleich sind.

3. Polymer nach Anspruch 1, worin R¹ und R² verschieden sind.

4. Polymer nach einem der Ansprüche 1 bis 3, worin R¹ und/oder R² eine substituierte oder unsubstituierte Phenyl-, Pyridin- oder Thiophengruppe umfaßt bzw. umfassen.

5. Polymer nach einem der Ansprüche 1 bis 4, worin R¹ und/oder R² eine Gruppe umfaßt bzw. umfassen, die die allgemeine Formel II, welche substituiert oder unsubstituiert ist, aufweist: 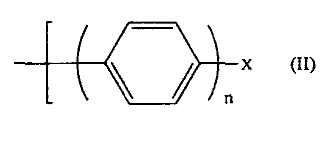 worin n 2 oder 3 ist, und X ausgewählt ist aus Wasserstoff, Alkyl, Aryl, Heteroaryl, Alkoxy, Arylalkyl, Alkylaryl, Cyano, Halogen, Halogenalkyl, Halogenaryl, Halogenheteroaryl oder Halogenalkoxy.

6. Polymer nach Anspruch 5, worin die Gruppe mit der allgemeinen Formel I eine in der allgemeinen Formel III gezeigte Formel aufweist: 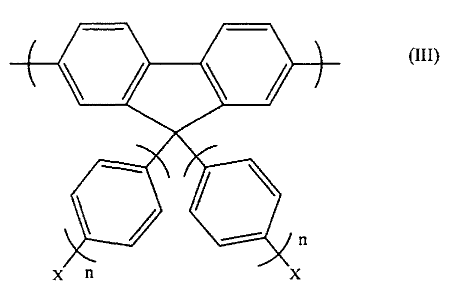 worin X und n, jeweils unabhängig voneinander, die in Anspruch 5 genannten Bedeutungen besitzen.

7. Polymer nach Anspruch 5 oder 6, worin X ausgewählt ist aus Wasserstoff, Alkyl, Halogenalkyl oder Alkoxy.

8. Polymer nach Anspruch 7, worin X ausgewählt ist aus Methyl, Ethyl, n-Butyl, s-Butyl oder tert-Butyl.

9. Polymer nach einem der Ansprüche 6 bis 8, worin n 2 ist.

10. Polymer nach einem der vorhergehenden Ansprüche, welches ferner eine zweite sich wiederholende Einheit † Ar † aufweist, die eine substituierte oder unsubstituierte Aryl- oder Heteroarylgruppe umfaßt.

11. Polymer nach Anspruch 10, worin Ar substituiert oder unsubstituiert ist und eine Fluoren-, Phenylen-, Phenylenvinylen-, Benzothiadiazol, Chinoxalin-, Thiophen-, Triarylamin-, bis-Triarylamin-, oder bis-(Diarylamin)arylen-Gruppe umfaßt.

12. Polymer nach einem der vorhergehenden Ansprüche, bei dem das Polymer ein Homopolymer umfaßt.

13. Polymer nach einem der Ansprüche 1 bis 11, bei dem das Polymer ein Copolymer umfaßt.

14. Polymer nach einem der vorhergehenden Ansprüche, worin der Polymerisationsgrad mindestens 4 beträgt.

15. Polymer nach einem der vorhergehenden Ansprüche, bei dem die Glasübergangstemperatur Tg mindestens 100°C beträgt.

16. Verwendung einer ersten sich wiederholenden Einheit gemäß einem der Ansprüche 1 bis 9 zum Transportieren von negativen Ladungsträgern in einem Polymer gemäß einem der vorhergehenden Ansprüche.

17. Verwendung eines Polymers gemäß einem der Ansprüche 1 bis 15 als Bauelement in einer optischen Anordnung.

18. Verwendung eines Polymers gemäß Anspruch 17, bei der die optische Anordnung eine elektrolumineszierende Anordnung umfaßt.

19. Optische Anordnung oder Bauelement dafür, die bzw. das ein Substrat und ein auf das Substrat aufgebrachtes Polymer gemäß einem der Ansprüche 1 bis 15 umfaßt.

20. Optische Anordnung oder Bauelement dafür gemäß Anspruch 19, wobei die optische Anordnung eine elektrolumineszierende Anordnung umfaßt.

21. Optische Anordnung gemäß Anspruch 20, bei dem die elektrolumineszierende Anordnung umfaßt:
eine erste Ladungsträger injizierende Schicht zum Injizieren von positiven Ladungsträgern;
eine zweite Ladungsträger injizierende Schicht zum Injizieren von negativen Ladungsträgern;
eine lichtemittierende Schicht, die sich zwischen den Ladungsträger injizierenden Schichten befindet, zur Aufnahme und Vereinigung von positiven und negativen Ladungsträgern unter Erzeugung von Licht; und
ein Polymer gemäß einem der Ansprüche 1 bis 15 zum Transport von negativen Ladungsträgern, das sich entweder zwischen der zweiten Ladungsträger injizierenden Schicht und der lichtemittierenden Schicht oder in der lichtemittierenden Schicht befindet.

22. Monomer zur Verwendung in einer Polymerisationsreaktion, das eine oder mehrere reaktionsfähige Gruppen und eine Monomereinheit mit der Struktur einer ersten sich wiederholenden Einheit gemäß einem der Ansprüche 1 bis 9 umfaßt.

23. Verfahren zur Herstellung eines Polymers, das einen Schritt umfaßt, bei dem ein erstes Monomer gemäß Anspruch 22 mit einem zweiten Monomer, das gleich oder vom ersten Monomer verschieden sein kann, unter solchen Bedingungen zur Reaktion gebracht wird, daß die Monomere polymerisieren.

24. Verfahren nach Anspruch 23 zur Herstellung eines Polymers gemäß einem der Ansprüche 1 bis 15, umfassend das Polymerisieren von:
(a) einem ersten aromatischen Monomer, umfassend entweder
(i) eine sich wiederholende Einheit gemäß einem der Ansprüche 1 bis 9; oder
(ii) eine zweite sich wiederholende Einheit, die gleich oder von der ersten sich wiederholenden Einheit verschieden sein kann, und mindestens zwei reaktionsfähige Bor-Derivat-Gruppen, die ausgewählt sind aus einer Boronsäuregruppe, einer Boronsäureestergruppe und einer Borangruppe; und
(b) einem zweiten aromatischen Monomer, das das jeweils andere der ersten oder zweiten sich wiederholenden Einheiten und mindestens zwei reaktiorisfähige Halogenfunktionalitäten umfaßt,
in einer Reaktionsmischung.

25. Verfahren nach Anspruch 23 zur Herstellung eines Polymers gemäß einem der Ansprüche 1 bis 15, umfassend das Polymerisieren von:
(a) einem ersten aromatischen Monomer, umfassend:
(i) eine erste sich wiederholende Einheit gemäß einem der Ansprüche 1 bis 9;
(ii) eine reaktionsfähige Bor-Derivat-Gruppe, die ausgewählt ist aus einer Boronsäuregruppe, einer Boronsäureestergruppe und einer Borangruppe; und
(iii)eine reaktionsfähige Halogenfunktionalität; und
(b) einem zweiten aromatischen Monomer, umfassend:
(i) eine zweite sich wiederholende Einheit, die gleich oder von der ersten sich wiederholenden Einheit verschieden sein kann;
(ii) eine reaktionsfähige Bor-Derivat-Gruppe, die ausgewählt ist aus einer Boronsäuregruppe, einer Boronsäureestergruppe und einer Borangruppe; und
(iii)eine reaktionsfähige Halogenfunktionalität,
in einer Reaktionsmischung.

## Revendications

1. Polymère possédant une première unité de répétition comprenant un groupe possédant une formule générale I qui est substituée ou non substituée: 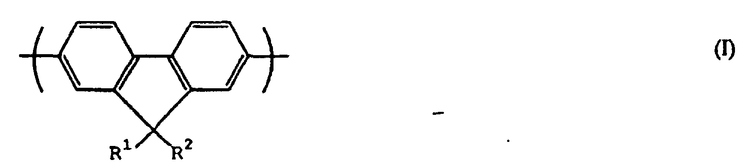 dans laquelle au moins l'un de R¹ ou R² comprend au moins deux groupes aryle ou hétéroaryle substitués ou non substitués et en excluant le groupe possédant une formule générale I dans laquelle un ou les deux R¹ et R² comprennent un groupe triarylamine.

2. Polymère selon la revendication 1, dans lequel R¹ et R² sont identiques.

3. Polymère selon la revendication 1, dans lequel R¹ et R² sont différents.

4. Polymère selon l'une quelconque des revendications 1 à 3, dans lequel au moins l'un de R¹ ou R² comprend un groupe phényle, pyridine, ou thiophène substitué ou non substitué.

5. Polymère selon l'une quelconque des revendications 1 à 4, dans lequel au moins l'un de R¹ ou R² comprend un groupe possédant une formule générale II qui est substituée ou non substituée: 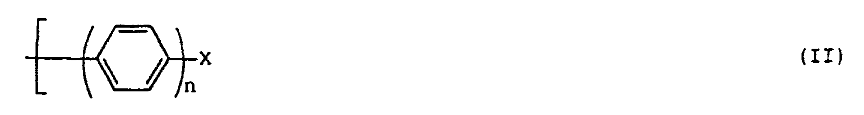 dans laquelle n représente 2 ou 3 et X est choisi parmi l'hydrogène, alkyle, aryle, hétéroaryle, alkoxy, arylalkyle, alkylaryle, cyano, halogénure, haloalkyle, haloaryle, halohétéroaryle ou haloalkoxy.

6. Polymère selon la revendication 5, dans lequel le groupe possédant une formule générale I possède une formule telle que présentée dans une formule générale III: 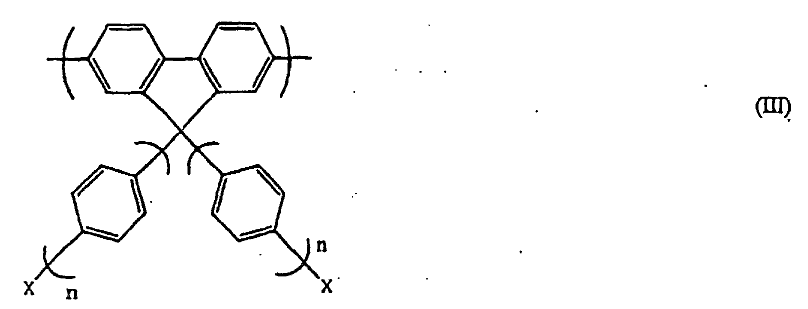 dans laquelle X et indépendamment chaque n sont tels que définis dans la revendication 5.

7. Polymère selon la revendication 5 ou la revendication 6, dans lequel X est choisi parmi l'hydrogène, alkyle, haloalkyle ou alkoxy.

8. Polymère selon la revendication 7, dans lequel X est choisi parmi méthyle, éthyle, n-butyle, s-butyle, butyle tertiaire.

9. Polymère selon l'une quelconque des revendications 6 à 8, dans lequel n représente 2.

10. Polymère selon l'une quelconque des revendications précédentes, possédant de plus une seconde unité de répétition + Ar + qui comprend un groupe aryle ou hétéroaryle substitué ou non substitué.

11. Polymère selon la revendication 10, dans lequel Ar est substitué ou non substitué et comprend un groupe fluorène, phénylène, phénylène vinylène, benzothiadiazole, quinoxaline, thiophène, triarylamine, bis triarylamine ou bis (diarylamine) arylène.

12. Polymère selon l'une quelconque des revendications précédentes, ledit polymère étant un homopolymère.

13. Polymère selon l'une quelconque des revendications 1 à 11, ledit polymère étant un copolymère.

14. Polymère selon l'une quelconque des revendications précédentes, dans lequel le degré de polymérisation est au moins 4.

15. Polymère selon l'une quelconque des revendications précédentes, dans lequel la Tg est au moins 100°C.

16. Utilisation d'une première unité de répétition telle que définie dans l'une quelconque des revendications 1 à 9 pour transport de supports de charge négative dans un polymère selon l'une quelconque des revendications précédentes.

17. Utilisation d'un polymère tel que défini dans l'une quelconque des revendications 1 à 15 comme composant dans un système optique.

18. Utilisation d'un polymère selon la revendication 17, dans laquelle le système optique comprend un système électroluminescent.

19. Système optique ou composant pour celui-ci, qui comprend un substrat et un polymère tel que défini dans l'une quelconque des revendications 1 à 15 supporté sur le substrat.

20. Système optique ou composant pour celui-ci selon la revendication 19, dans lequel le système optique comprend un système électroluminescent.

21. Système optique selon la revendication 20, dans lequel le système électroluminescent comprend:
une première couche d'injection de support de charge pour injecter des supports de charge positive ;
une seconde couche d'injection de support de charge pour injecter des supports de charge négative ;
une couche émettant de la lumière localisée entre les couches d'injection de support de charge pour accepter et combiner des supports de charge positive et négative pour générer de la lumière ; et
un polymère tel que défini dans l'une quelconque des revendications 1 à 15 pour transporter des supports de charge négative et soit localisé entre la seconde couche d'injection de support de charge et la couche émettant de la lumière, soit localisé dans la couche émettant de la lumière.

22. Monomère pour utilisation dans une réaction de polymérisation, comprenant un ou plusieurs groupes réactifs et une unité monomérique possédant la structure d'une première unité de répétition telle que définie dans l'une quelconque des revendications 1 à 9.

23. Procédé pour préparer un polymère comprenant une étape de réaction d'un premier monomère tel que défini dans la revendication 22 avec un second monomère qui peut être identique ou différent du premier monomère dans des conditions de manière à polymériser les monomères.

24. Procédé selon la revendication 23 pour préparer un polymère tel que défini dans l'une quelconque des revendications 1 à 15 qui comprend une polymérisation dans un mélange réactionnel de:
(a) un premier monomère aromatique comprenant soit:
(i) une première unité de répétition telle que définie dans l'une quelconque des revendications 1 à 9 ; soit
(ii) une seconde unité de répétition qui peut être identique ou différente de la première unité de répétition ;
et au moins deux groupes dérivés du bore réactifs choisis parmi un groupe acide boronique, un groupe ester boronique et un groupe borane ; et
(b) un second monomère aromatique comprenant l'autre de la première ou seconde unité de répétition et au moins deux groupes fonctionnels halogénure réactifs.

25. Procédé selon la revendication 23 pour préparer un polymère tel que défini dans l'une quelconque des revendications 1 à 15 qui comprend une polymérisation dans un mélange réactionnel de:
(a) un premier monomère aromatique comprenant:
(i) une première unité de répétition telle que définie dans l'une quelconque des revendications 1 à 9 ;
(ii) un groupe dérivé du bore réactif choisi parmi un groupe acide boronique, un groupe ester boronique et un groupe borane ; et
(iii) un groupe fonctionnel halogénure réactif ; et
(b) un second monomère aromatique comprenant:
(i) une seconde unité de répétition qui est identique ou différente de la première unité de répétition ;
(ii) un groupe dérivé du bore réactif choisi parmi un groupe acide boronique, un groupe ester boronique et un groupe borane ; et
(iii) un groupe fonctionnel halogénure réactif.
